## Europäisches Patentamt

## European Patent Office

## Office européen des brevets

(19)

(11) Veröffentlichungsnummer: **0 121 068**
**B1**

(12) **EUROPÄISCHE PATENTSCHRIFT**

(45) Veröffentlichungstag der Patentschrift:
13.01.88

(51) Int. Cl.⁴: **H 01 L 29/10**, H 01 L 29/08,
H 01 L 29/743

(21) Anmeldenummer: **84101720.5**

(22) Anmeldetag: **20.02.84**

(54) **Leistungshalbleiterbauelement und Verfahren zu dessen Herstellung.**

(30) Priorität: **31.03.83 CH 1793/83**

(43) Veröffentlichungstag der Anmeldung:
**10.10.84 Patentblatt 84/41**

(45) Bekanntmachung des Hinweises auf die Patenterteilung:
**13.01.88 Patentblatt 88/2**

(84) Benannte Vertragsstaaten:
**CH DE FR GB IT LI NL**

(56) Entgegenhaltungen:
**EP-A-0 022 355**
**EP-A-0 064 613**
**EP-A-0 066 850**
**DE-A-2 719 219**
**DE-A-3 134 074**
**US-A-4 127 863**

(73) Patentinhaber: **BBC Brown Boveri AG, CH- 5401
Baden (CH)**

(72) Erfinder: **Gobrecht, Jens, Dr., Birchhofstrasse 6,
CH- 5412 Gebenstorf (CH)**
Erfinder: **Roggwiller, Peter, Dr., Puentstrasse 712,
CH- 8173 Riedt- Neerach (CH)**
Erfinder: **Sittig, Roland, Dr., Rinikerstrasse 102,
CH- 5222 Umiken (CH)**
Erfinder: **Voboril, Jan, Landschreiberstrasse 2, CH-
5415 Nussbaumen (CH)**

EP 0 121 068 B1

## Beschreibung

Die Erfindung betrifft ein Leistungshalbleiterbauelement nach dem Oberbegriff des Anspruchs 1, und ein Verfahren zu dessen Herstellung.

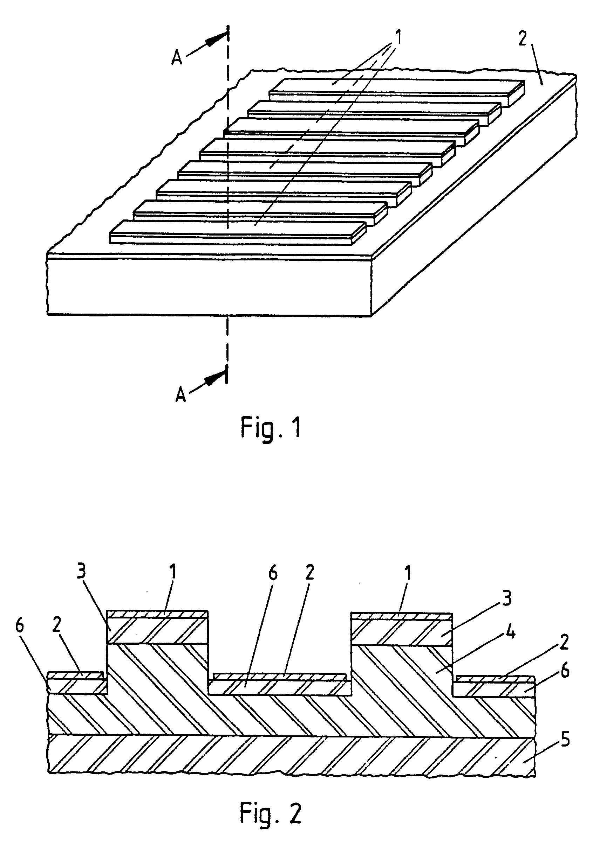

Ein solches Bauelement ist z. B. bekannt aus der DE-A-27 19 219. Die dort beschriebene Halbleitervorrichtung weist vier Schichten in einer pnpn-Anordnung auf. Die n-dotierte Kathodenschicht 8 ist in mehrere Abschnitte unterteilt, un eine Kontaktierung in zwei Ebenen zu ermöglichen (Fig. 1) Sie besitzt eine Oberflächendotierung von $5 \times 10^{20}$ Atome/cm$^3$ und ist 10 µm dick. Die darunterliegende p-Basisschicht 6 besitzt eine Oberflächendotierung von $2 \times 10^{18}$ Atome/cm$^3$ und ist 53 µm dick. Die Breite der Kathoden-Abschnitte beträgt mindestens 320 µm. Die maximale Sperrspannung des pn-Übergangs zwischen Kathodenschicht 8 und p-Basis 6 beträgt 10 Volt. Die beschriebene Halbleitervorrichtung ist für eine Gesamtstromkapazität von 400 A ausgelegt. Es wird ebenfalls ein Verfahren zur Herstellung der obengenannten Halbleitervorrichtung angegeben (Fig. 6). Dazu wird zunächst auf beiden Seiten eines n-dotierten Siliziumsubstrates 42 Bor oder Gallium eindiffundiert. Die Dotierung des n-Substrates betragt etwa $10^{13}$ - $10^{16}$ Atome/cm$^3$. Die eindiffundierten p-Schichten, die p-Basisschicht 46 und die Anode 44 besitzen eine Oberflächen-Dotierung von etwa $2 \times 10^{18}$ Atome/cm$^3$. In die p-Basisschicht 46 wird Phosphor zur Bildung der Kathodenschicht 48 eindiffundiert. Diese n-Schicht 48 wird photolithographisch in mehrere Abschnitte unterteilt. Anschliessend werden Aluminiumschichten auf die Anodenschicht 44, auf die Kathodenabschnitte 48 und die unterteilten p-Basisschichten 46 aufgebracht.

Die bekannte Halbleitervorrichtung lässt sich durch Anlegen eines negativen Stromimpulses an der p-Basisschicht 6 (Gate) abschalten. Die dazu notwendige, von aussen zugeführte Leistung ist beträchtlich. Durch diesen Stromimpuls wird der Laststrom gegen die Mitte eines Kathodenabschnittes hin eingeschnürt und ein Teil des Laststroms wird so zum Gate abgesaugt. Die Stromdichte des übrigbleibenden Laststroms wird dann sehr hoch. Falls der Abschaltvorgang zu langsam - z. B. bei zu hoher Abschaltverstärkung - oder nicht homogen über die gesamte Fläche der Halbleitervorrichtung abläuft, wird sie lokal thermisch überbelastet und demzufolge zerstört. Der Abschaltstrom über das Gate erzeugt einen lateralen Spannungsabfall, der kleiner als die Durchbruchspannung des pn-Übergangs zwischen Kathode und p-Basisschicht sein sollte. Die maximale Sperrspannung dieses pn-Übergangs ist jedoch so niedrig, dass ein Lawinendurchbruch dieses Übergangs während des Abschaltvorgangs auftreten kann. Das beschriebene Herstellungsverfahren ist zwar ausreichend für die Struktur mit den Dimensionen der bekannten Halbleitervorrichtung, jedoch feinere Strukturen können damit kaum befriedigend angefertigt werden.

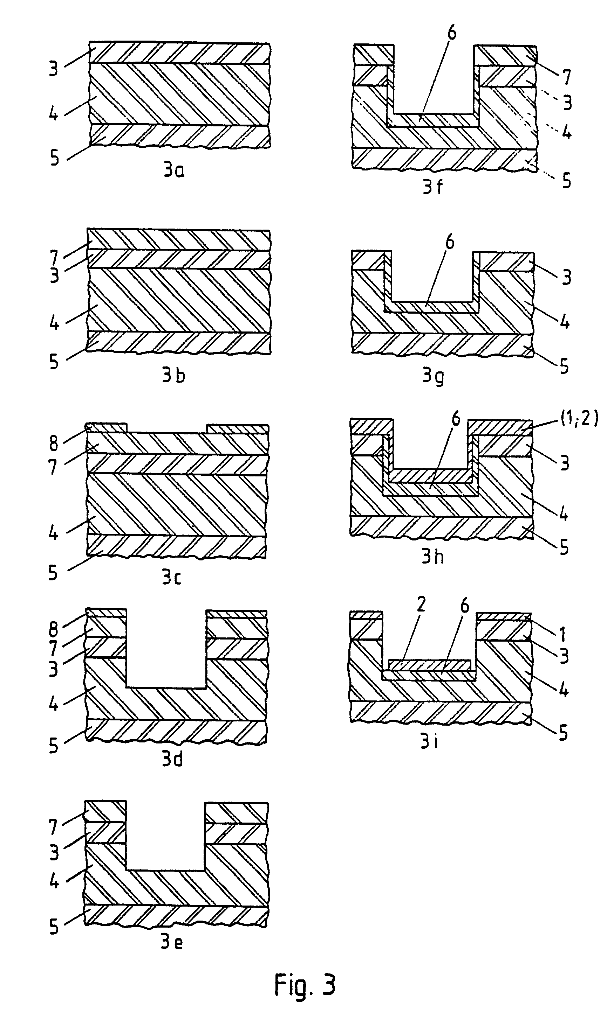

In der DE-A-28 55 546 ist ein feldgesteuerter Thyristor beschrieben, der Kennlinien ähnlich einer P-I-N-Diode aufweist. Dieser Thyristor besteht aus einem dünnen, stark p-dotierten Anodenbereich 15, einem dicken schwach n-dotierten Halbleitersubstrat 11, mehreren tiefen p-dotierten Gitterbereichen 12 und dazwischen angeordneten dünnen, stark n-dotierten Kathodenbereichen 14 (Fig. 3). Die Gitterbereichne 12 bestehen aus Kanälen mit einer Weite von etwa 12 µm und einer Tiefe von 15 bis 40 µm. Zur Herstellung dieser Gitterbereich 12 werden Kanäle in ein <110>-orien-tiertes Siliziumsubstrat geätzt mit einer Mischung aus Kaliumhydroxid und Isopropanol in einem Verhältnis von etwa 3 : 1 (Fig. 1). Dazu wurde zunächst eine Maske 13 aus Siliziumdioxid gebildet. Die Kanäle werden dann epitaktisch mit stark p-dotiertem Silizium wieder aufgefüllt. Es bildet sich dann zusätzlich eine dünne Schicht Polysilizium auf der Siliziumoxid-Schicht, die durch Aetzen entfernt wird. Es wird nun eine Maske aus Siliziumoxid für die Kathodenbereiche 14 gebildet, die durch Phosphordiffusion geschaffen werden. Die Gitterbereiche 12 und die Kathodenbereiche 14 werden schlussendlich mit Metallisierungen versehen, wobei zur elektrischen Isolation Siliziumdioxid dazwischen belassen wird.

Das für das beschriebene Verfahren benötigte Silizium mit <110>-Orientierung kann nicht versetzungsfrei gezogen werden. Deshalb kann man die Siliziumscheiben nur in elliptischer Form erhalten, die zur weiteren Verarbeitung rund gesandstrahlt werden müssen. Das Grundmaterial für das beschriebene Bauelement ist daher viel teurer als für übliche Bauelemente.

Es ist deshalb Aufgabe der Erfindung, bei einem Halbleiterbauelement der vorgenannten Art sicheres Ausschalten bei kleiner Verlustleistung und hoher Stromfestigkeit zu erreichen. Zudem ist es Aufgabe der Erfindung, ein möglichst einfaches Verfahren zur Herstellung von Halbleiterbauelementen anzugeben, die die erfindungsgemässe feinere Oberflächenbeschaffenheit aufweisen.

Diese Aufgaben werden durch die Merkmale der Ansprüche 1 und 6 gelöst.

Das erfindungsgemässe Leistungshalbleiterbauelement hat unter anderem den Vorteil, dass es auch unter grossen Strombelastungen bei hohen Schaltfrequenzen stets sicher abgeschaltet werden kann. Die erfindungsgemäss niedrige Dotierung der zweiten Schicht des Bauelementes gewährleistet, dass der Strom über das Gate schnell abgeführt wird. Dadurch werden die Abschaltverzögerungen minimal und somit viel schnellere Abschalteigenschaften erreicht. Das erfindungsgemässe Herstellungsverfahren ist besonders wirtschaftlich, da die Oberflächenstrukturierung mit einer einzigen Maske erzeugt wird.

Im folgenden wird die Erfindung anhand von lediglich einen Ausführungsweg darstellenden Zeichnung näher erläutert. Dabei zeigt:

Fig. 1 die Oberflächenstrukturierung eines erfindungsgemässen Bauelementes,

Fig. 2 einen Teil des Schnittes längs der Linie A-A in Figur 1,

Fig. 3 die verschiedenen Schritte eines erfindungsgemässen Herstellungsverfahrens.

In Figur 1 ist ein Teil eines Leistungshalbleiterbauelementes mit erfindungsgemässer Oberflächenstruktur dargestellt. Auf der hochdotierten ersten Halbleiterschicht, die aus parallelen stufenförmigen Streifen besteht, befindet sich eine erste metallische Kontaktebene 1. Eine tieferliegende zweite metallisierte Kontaktebene 2 umgibt die parallelen Streifen und dient zur Kontaktierung der niedrigdotierten zweiten Halbleiterschicht. Die genaue Schichtenfolge, zumindest was den oberen Teil des Bauelementes betrifft, ist aus der Figur 2 ersichtlich. Unterhalb der ersten Kontaktebene 1 befindet sich in dem oberen Teil der Streifen eine hochdotierte erste Halbleiterschicht 3. Der angrenzende untere Teil der Streifen wird von einer niedrigdotierten zweiten Schicht 4 gebildet, die sich unterhalb der zweiten Kontaktebene 2 über das ganze Bauelement erstreckt. Angrenzend an die zweite Schicht 4 ist mindestens noch eine dritte Schicht 5 angeordnet. Zwischen der zweiten Kontaktebene 2 und der zweiten Schicht 4 ist eine hochdotierte vierte Schicht 6 angeordnet. Sie befindet sich angrenzend an der zweiten Kontaktebene 2 und wird seitlich von der zweiten Schicht 4 begrenzt. Bei dem in Fig. 3 dargestellten Herstellungsverfahren eines erfindungsgemässen Bauelementes sind für die gleichen Elemente wie in den Figuren 1 und 2 die gleichen Bezugszeichen verwendet. Um die genaue Struktur der Oberfläche des Bauelementes anzufertigen, wird eine Siliziumdioxid-Schicht 7 und eine Aluminium-Maske 8 verwendet.

Im einzelnen werden nun zwei für die Erfindung besonders geeignete Bauelemente vorgestellt.

Die erfindungsgemässe Oberflächenstruktur und die niedrige Dotierung der zweiten Schicht hat sich zum ersten besonders bewährt bei einem über das Gate abschaltbaren Thyristor. Ein solcher Thyristor hat die übliche pnpn-Schichtenfolge, und ist z. B. aus der DE-A-27 19 219 (Fig. 1) bekannt. Bei der Schichtenfolge gemäss Fig. 2 sieht dies folgendermassen aus:

- die erste Schicht 3, die Kathodenschicht hat eine hohe n-Dotierung von $5 \cdot 10^{18}$ bis $5 \cdot 10^{20}/cm^3$,
- die zweite Schicht 4, die p-Basisschicht, hat eine niedrige p-Dotierung von $5 \cdot 10^{14}$ bis $5 \cdot 10^{16}/cm^3$,
- die dritte Schicht 5, die n-Basisschicht, hat eine niedrige n-Dotierung von $5 \cdot 10^{14}$ bis $5 \cdot 10^{16}/cm^3$,
- die vierte Schicht 6 besitzt eine hohe p-Dotierung von $5 \cdot 10^{18}$ bis $5 \cdot 10^{20}/cm^3$, und
- eine (nicht-dargestellte) fünfte Schicht, die Anodenschicht, die an der n-Basisschicht 5 angrenzt, hat eine hohe p-Dotierung von $5 \cdot 10^{17}$ bis $5 \cdot 10^{19}/cm^3$.

Auf der fünften Schicht ist noch eine (ebenfalls nicht-dargestellte) metallisierte dritte Kontaktebene vorgesehen. Um die stufenförmigen Streifen richtig zu dimensionieren, sind folgende Überlegungen zu berücksichtigen: Während des Abschaltvorganges ist der maximale Querstrom zur zweiten Kontaktebene 2 durch die Durchbruchspannung über den pn-Übergang zwischen der Kathodenschicht 3 und der p-Basisschicht 4 begrenzt. Unter der Annahme eines homogenen axialen Stromflusses $j_Z$ aus der n-Basisschicht 5 ergibt sich für die maximale Querstromdichte:.

$$j_Q \cong 4 \cdot 10^{-5} \cdot \mu_p \cdot \tilde{N}_p^{1/4} \frac{W_p}{x_E^2} \left[\frac{A}{cm^2}\right], \quad (1)$$

wobei

$\mu_p$ = Beweglichkeit der Löcher in der p-Basisschicht 4

$\tilde{N}_p$ = mittlere Dotierung der p-Basisschicht 4

$W_p$ = Dicke der p-Basisschicht 4 unter der ersten Kontaktebene 1

$x_E$ = Breite eines stufenförmigen Streifens

Aus der Formel (1) folgt, dass eine Verringerung der Streifenbreite $x_E$ und eine niedrigere Dotierung $\tilde{N}_p$ der p-Basisschicht 4 den Querstrom $J_Q$ beim Abschalten nicht beschränken. Die maximalen lokalen Stromdichten während des Abschaltvorganges verringern sich proportional zur Streifenbreite $x_E$, was einer homogenen Verteilung der Verlustleistung gleichkommt. Unter der gleichen Annahme wie in Formel (1) lässt sich die axiale Stromdichte $j_Z$ in Abhängigkeit von der Gate-Abschaltspannung $U_G$ abschätzen:

$$j_Z(U_G) \cong 4 \cdot \tilde{N}_p \cdot e \cdot \mu_p \cdot W_p \cdot \frac{U_G}{x_E^2} \quad (2)$$

mit e = Elementarladung.

Für $\tilde{N}_p = 10^{15}\,cm^{-3}$, $x_E = 50\,\mu m$ und $W_p = 40\,\mu m$ ergibt sich dann eine Stromdichte beim Abschalten von

$$J_Z(U_G) \cong 26 \cdot U_G\ [A/cm^2]$$

Wenn das Potential von der Mitte eines Streifens linear zur zweiten Kontaktebene 2 abnimmt, bedeutet dies, dass sich die Ladungsträger bei einer Gatespannung $U_G$ von -40 V bereits annähernd mit Sättigungsgeschwindigkeit bewegen. Dieser Wert der Gatespannung liegt wesentlich unter der Durchbruchspannung des pn-Überganges zwischen Kathodenschicht 3 und p-Basisschicht 4.

Um eine ausreichende Potentialtrennung zwischen den beiden Kontaktebenen 1 und 2 zu erreichen, ist eine Höhe der stufenförmigen Streifen von mindestens 10 μm bis 20 μm erforderlich. Die Breite der Streifen liegt zwischen 20 μm und 300 μm und das Verhältnis zwischen der gesamten Oberfläche der ersten Kontaktebene 1 und der gesamten Oberfläche der zweiten Kontaktebene 2 beträgt zwischen 1 und 4. Dadurch ist gewährleistet, dass die abzuführende Verlustleistung beim Abschalten genügend homogen über das Bauelement verteilt wird. Eine lokale Erwärmung des Bauelementes ist deshalb ausgeschlossen, auch bei weit über die nominellen Werte hinausgehenden Spitzenspannungen und -strömen. Durch die Kombination der sehr feinen Struktur der Kathodenschicht 3 und der niedrigen Dotierung der p-Basisschicht 4 breitet sich die Verarmungsschicht unter der ganzen Breite des Streifens bis tief zur zweiten Kontaktebene 2 aus. Hierdurch kann der grösste Teil der Ladungen, die während des Durchlasses in die p-Basisschicht 4 injiziert sind, als Feldstrom abgeführt werden. Nur der kleinere Teil dieser Ladungen rekombiniert. Dies führt zu einer wesentlichen Verbesserung der Schaltgeschwindigkeit des Bauelementes.

Zum zweiten ist die Erfindung besonders erfolgreich bei feldgesteuerten Thyristoren angewandt worden. Ein solches Bauelement ist z. B. aus der DE-A-28 55 546 bekannt. Dieses besteht aus drei Halbleiterschichten (Fig. 1 der Offenlegungsschrift). Für ein erfindungsgemässes Bauelement nach Fig. 2 sieht der Schichtenaufbau wie folgt aus:
- die erste Halbleiterschicht 3, die Kathodenschicht, besitzt eine hohe n-Dotierung von $5 \cdot 10^{18}$ bis $5 \cdot 10^{20}/cm^3$,
- die zweite Halbleiterschicht 4, die intrinsische Schicht, besitzt eine niedrige n-Dotierung von $5 \cdot 10^{14}$ bis $5 \cdot 10^{16}/cm^3$, und
- die dritte und die vierte Halbleiterschicht 5 und 6, die Anodenschicht und die Gate-Bereiche, besitzen eine hohe p-Dotierung von $5 \cdot 10^{18}$ bis $5 \cdot 10^{20}/cm^3$.

Bei diesem Bauelement ist auf der dritten Halbleiterschicht 5 noch eine (nicht-dargestellte) dritte metallisierte Kontaktebene vorgesehen. Auch bei diesem Bauelement sind die erfindungsgemässe Stufenhöhe, Stufenbreite und das Verhältnis der Oberflächen der Kontaktebenen 1 und 2 einzuhalten. Die Wirkungsweise des Bauelementes ist im Prinzip gleich wie in der DE-A-28 55 546 beschrieben (vgl. dort Seiten 10 bis 14). Da die Gate-Bereiche 6 des erfindungsgemässen Bauelementes tiefer liegen als die Kathodenschicht 3, wird der Laststrom während des Abschaltens schneller von den Verarmungsschichten eingeschnürt. Auch ist durch die zwei Kontaktebenen 1 und 2 eine grössere Belastbarkeit des Bauelementes gewährleistet. Ein anderer Vorteil der Erfindung ist, daß die erfindungsgemässen Bauelemente viel einfacher herzustellen sind, wie weiter unten ausgeführt wird.

Es versteht sich, dass die erfindungsgemässe Struktur nicht auf die Streifenform beschränkt ist, obwohl diese herstellungsmässig am geeignetesten ist. Eine stufenförmige Oberflächenstruktur kann auch mit Ringen, sektorförmigen Gebilden oder dergleichen erreicht werden. Die erfindungsgemässe Stufenhöhe, Stufenbreite und das Verhältnis zwischen den Oberflächen der Kontaktebenen 1 und 2 sollten dabei stets eingehalten werden.

Das erfindungsgemässe Herstellungsverfahren wir nachfolgend anhand der Fig. 3 für einen über das Gate abschaltbaren Thyristor näher erläutert.

Eine Siliziumscheibe wird zunächst in üblicher Weise mit einer pnpn-Schichtenfolge versehen. Dazu wird zuerst die Siliziumscheibe, die eine Grunddotierung mit n-Material von $2 \cdot 10^{13}$ - $2 \cdot 10^{14}/cm^3$ aufweist, ganzflächig mit einer p-Schicht versehen, durch Anbringen einer Randkonzentration von $3 \cdot 10^{15}/cm^3$ und Diffusion mit einer Eindringtiefe von 40 μm. Durch planare Phosphordiffusion mit einer Eindringtiefe von etwa 3 bis 5 μm wird eine Kathodenschicht 3 auf der Siliziumscheibe erzeugt (Fig. 3a). Darauf wird eine Schicht Siliziumdioxid 7 durch Oxydieren bei 1300 bis 1500 K aufgebracht (Fig. 3b). Es wird eine Aluminium-Schicht 8 von 2 μm Dicke aufgedampft und mittels eines photolithographischen Prozesses eine Maske daraus gebildet (Fig. 3c). Durch reaktives Ionenätzen werden dort, wo die Aluminium-Maske 8 nicht vorhanden ist, Gräben von etwa 20 μm Tiefe geätzt (Fig. 3d). Solche Ätzmethoden sind z. B. bekannt aus J. Electrochem. Soc. Reviews and News, Volume 129, No. 3, Seiten 62C bis 66C (März 1982). In diesem speziellen Fall wird für das Plasma $SF_6$ verwendet bei einem Vakuum von 50 μbar. An der Siliziumscheibe stellt sich dann eine Spannung von 150 bis 200 Volt ein. Die Hochfrequenz beträgt 13,56 MHz und die Hf-Leistungsdichte z. B. 0,6 Watt/cm². Damit wird eine Ätzrate von 100 bis 500 μm/Minute erreicht. Der Ätzprozess selber ist stark anisotrop, d.h. vornehmlich in Richtung des elektrischen Feldes, so dass sehr scharfe Konturen erreicht werden.

Die Aluminium-Maske 8 wird dann bei einer Temperatur von etwa 350 K und etwa 1 bis 2 Minuten Ätzzeit vollständig entfernt (Fig. 3e). Ein Liter der dazu verwendeten Beize besteht aus 720 ml $H_3PO_4$ (85 %), 144 ml $H_2O$ und 36 ml $HNO_3$ (65 %). Die Gräben werden nun durch eine kurze Bordiffusion mit einer dünnen (etwa 1 bis 2 um) hochdotierten p-Schicht 6 belegt (Fig. 3f). Da die Diffusion vor allem in die axiale Richtung erfolgt, ist die Belegung der Gräbenwände viel geringer als in den Gräben selber. Nach dieser Diffusion wird die Siliziumdioxid-Schicht 7 nasschemisch (z. B. mit HF) bei einer Temperatur von 360 K und einer Ätzzeit von etwa einer Minute entfernt (Fig. 3g). Über die so strukturierte Oberfläche des Bauelementes wird eine dünne Aluminium-Schicht 1, 2 aufgedampft (Fig. 3h). Da dieser Prozess ebenfalls vor allem axial abläuft, ist die Randbelegung ebenfalls minimal. Die Aluminium-Schicht 1, 2 und die hochdotierte p-Schicht 6 werden nun isotrop nasschemisch oder mit Plasma weggeätzt, bis die Schichten auf den Wänden vollständig entfernt sind. Die Belegung auf den Oberflächen der Kontaktebenen 1 und 2 ist dann noch mehr als ausreichend (Fig. 3i). Dazu wird eine Beize von 65-prozentigem $HNO_3$ und 49-prozentigem HF im Verhältnis 10 : 1 verwendet. Zur Kontrolle wird die Sperrspannungscharakteristik zwischen den Kontaktebenen 1 und 2 aufgenommen, die der einer Diode entsprechen sollte. Obwohl das beschriebene Herstellungsverfahren am zweckmässigsten ist, gibt es selbstverständlich für die einzelnen Prozeßschritte andere Möglichkeiten. Z. B. kann beim letzten Schritt zunächst die Aluminium-Schicht 1, 2 mittels einer selektiven Beize isotrop geätzt werden und dann erst die p-Schicht 6 mit der angegebenen Methode. Die Kontrolle auf noch vorhandene Randbelegungen geschieht wie oben.

**Patentansprüche**

1. Leistungshalbleiterbauelement mit mindestens drei aufeinanderfolgenden Schichten unterschiedlicher Leitfähigkeit, wobei
- die ersten zwei Schichten (3, 4) bis zu einer ersten Oberfläche des Bauelementes reichen,
- die erste Schicht (3) hochdotiert ist,
- eine erste (1) und eine zweite (2), in Abschnitte unterteilte Kontaktebene zur Kontaktierung der ersten (3) bzw. der zweiten Schicht (4) vorgesehen sind, die der ersten Oberfläche des Bauelementes eine stufenförmige Struktur aufprägen, dadurch gekennzeichnet, dass
- die erste Schicht (3) etwa 3-5 µm dick ist,
- die zweite Schicht (4) niedrigdotiert und maximal 40 µm dick ist,
- die Stufen zwischen 10 µm und 20 µm hoch sind und zwischen 20 µm und 300 µm breit sind, und
- das Verhältnis zwischen der Oberfläche der ersten Kontaktebene (1) und der Oberfläche der zweiten Kontaktebene (2) zwischen 1 und 4 beträgt.
2. Leistungshalbleiterbauelement nach Anspruch 1, dadurch gekennzeichnet, dass an der Oberfläche der zweiten Kontaktebene (2) eine vierte Schicht (6) mit einem dem der ersten Schicht (3) entgegengesetzten Leitfähigkeitstyp vorgesehen ist.
3. Leistungshalbleiterbauelement nach Anspruch 1, dadurh gekennzeichnet, dass die erste Schicht (3) eine Dotierung von $5 \cdot 10^{18}$ bis $5 \cdot 10^{20}$ Atome/cm$^3$ und die zweite Schicht (4) eine Dotierung von $5 \cdot 10^{14}$ bis $5 \cdot 10^{16}$ Atome/cm$^3$ aufweist.
4. Verfahren zur Herstellung eines Halbleiterbauelementes nach Anspruch 1, bei welchem Verfahren
- auf eine zweite Schicht (4) niedrigdotierten Halbleitermaterials durch Diffusion eine erste hochdotierte Schicht (3) erzeugt wird,
- darüber photolithographisch eine Maske (8) aus einem ätzresistenten Material gebildet wird, die die stufenförmige Struktur der Oberfläche im wesentlichen festlegt,
- sodann bis in die zweite niedrigdotierte Schicht Gräben geätzt werden,
- die Maske (8) wieder entfernt wird, dadurch gekennzeichnet, dass
- die Diffusion der ersten hochdotierten Schicht (3) mit einer Eindringtiefe von etwa 3-5 µm erfolgt und die Dicke der zweiten Schicht auf maximal 40 µm verringert,
- eine Maske (8) verwendet wird, derart, dass das Verhältnis zwischen der Oberfläche einer ersten Kontaktebene (1) und der Oberfläche einer zweiten Kontaktebene (2) zwischen 1 und 4 beträgt,
- die Ätzung der Gräben durch reaktives Ionenätzen mit einer Ätztiefe von 10 µm bis 20 µm und einem Grabenabstand von 20 µm bis 300 µm erfolgt,
- nach Entfernung der Maske (8) eine dünne Metallschicht (1, 2) für die Kontaktierung über die ganze Oberfläche aufgedampft wird, und
- die Oberfläche isotrop geätzt wird, bis die dünne Metallschicht (1, 2) an den Seitenwänden der Gräben vollständig entfernt ist.
5. Verfahren zur Herstellung eines Halbleiterbauelementes nach Anspruch 2, bei welchem Verfahren
- auf eine zweite Schicht (4) niedrigdotierten Halbleitermaterials durch Diffusion eine erste hochdotierte Schicht (3) erzeugt wird,
- darüber photolithographisch eine Maske (8) aus einem ätzresistenten Material gebildet wird, die die stufenförmige Struktur der Oberfläche im wesentlichen festlegt,
- sodann bis in die zweite niedrigdotierte Schicht (4) Gräben geätzt werden,
- die Maske (8) wieder entfernt wird, dadurch gekennzeichnet, dass
- die Diffusion der ersten hochdotierten Schicht (3) mit einer Eindringtiefe von etwa 3-5 µm erfolgt und die Dicke der zweiten Schicht (4) auf maximal 40 µm verringert,
- eine Maske (8) verwendet wird, derart, dass das Verhältnis zwischen der Oberfläche einer ersten Kontaktebene (1) und der Oberfläche einer zweiten Kontaktebene (2) zwischen 1 und 4 beträgt,
- die Ätzung der Gräben durch reaktives Ionenätzen mit einer Ätztiefe von 10 µm bis 20 µm und einem Grabenabstand von 20 µm bis 300 µm erfolgt,
- vor der Bildung der Maske (8) auf die erste hochdotierte Schicht (3) eine Schicht aus Siliziumdioxid (7) aufgebracht wird,
- nach Entfernung der Maske (8) durch Diffusion die vierte hochdotierte Schicht (6) an der Oberfläche der zweiten Kontaktebene erzeugt wird,
- nach der Diffusion der vierten hochdotierten Schicht (6) die Schicht Siliziumdioxid (7) vollständig entfernt wird,
- eine dünne Metallschicht (1, 2) für die Kontaktierung über die ganze Oberfläche aufgedampft wird, und

- die Oberfläche isotrop geätzt wird bis die Metallschicht (1, 2) und die vierte hochdotierte Schicht (6) an den Seitenwänden der Gräben vollständig entfernt sind.

6. Verfahren nach Anspruch 4 oder 5, dadurch gekennzeichnet, dass das Material der Metallschicht (1, 2) sowie der Maske (8) Aluminium ist.


**Claims**

1. Power semiconductor component comprising at least three successive layers of different conductivity, in which

- the first two layers (5, 4) extend to a first surface of the component,
- the first layer (3) is highly doped,
- a first (1) and a second (2) contact plane divided into sections are provided for making contact to the first (3) or the second layer (4) and impart a steplike structure to the first surface of the component, characterized in that
- the first layer (3) is about 3-5 µm thick,
- the second layer (4) is weakly doped and is a maximum of 40 µm thick,
- the steps are between 10 µm and 20 µm high and are between 20 µm and 300 µm wide, and
- the ratio between the surface of the first contact plane (1) and the surface of the second contact plane (2) is between 1 and 4.

2. Power semiconductor element according to claim 1, characterized in that a fourth layer (6) having a conductivity opposite to that of the first layer (3) is provided on the surface of the second contact plane (2).

3. Power semiconductor according to claim 1, characterized in that the first layer (3) has a doping of $5 \cdot 10^{18}$ to $5 \cdot 10^{20}$ atoms/cm³ and the second layer (4) has a doping of $5 \cdot 10^{14}$ to $5 \cdot 10^{16}$ atoms/cm³.

4. Method for manufacturing a semiconductor component according to claim 1, in which method

- a first highly doped layer (3) is produced on a second layer (4) of weakly doped semiconductor material by diffusion,
- a mask (8) of an etch-resistant material is formed thereon by photolithography and essentially defines the step-like structure of the surface,
- trenches are then etched down into the second weakly doped layer,
- the mask (8) is removed again, characterized in that,
- the diffusion of the first highly doped layer (3) is performed with a penetration depth of about 3-5 µm and the thickness of the second layer is reduced to a maximum of 40 µm,
- use is made of a mask (8) which is such that the ratio between the surface of a first contact plane (1) and the surface of a second contact plane (2) is between 1 and 4,
- the etching of the trenches is performed by reactive ion etching with an etching depth of 10 µm to 20 µm and trench spacing of 20 µm to 300 µm,
- after removal of the mask (8) a thin metal layer (1, 2) for making contact is deposited by evaporation over the entire surface, and
- the surface is isotropically etched until the thin metal layer (1, 2) is completely removed at the side walls of the trenches.

5. Method for manufacturing a semiconductor component according to claim 2, in which method

- a first highly doped layer (3) is produced on a second layer (4) of weakly doped semiconductor material by diffusion,
- a mask (8) of an etch-resistant material is formed thereon by photolithography and essentially defines the step-like structure of the surface,
- trenches are then etched down into the second weakly doped layer (4),
- the mask (8) is removed again, characterized in that
- the diffusion of the first highly doped layer (3) is performed with a penetration depth of about 3-5 µm and the thickness of the second layer (4) is reduced to a maximum of 40 µm,
- use is made of a mask (8) which is such that the ratio between the surface of a first contact plane (1) and the surface of a second contact plane (2) is between 1 and 4,
- the etching of the trenches is performed by reactive ion etching with an etching depth of 10 µm to 20 µm and a trench spacing of 20 µm to 300 µm,
- before the mask (8) is formed on the first highly doped layer (3), a layer of silicon dioxide (7) is deposited,
- after removal of the mask (8) the fourth highly doped layer (6) is produced at the surface of the second contact plane by diffusion,
- after the diffusion of the fourth highly doped layer (6), the layer of silicon dioxide (7) is completely removed,
- a thin metal layer (1, 2) for making contact is deposited by evaporation over the entire surface, and
- the surface is isotropically etched until the metal layer (1, 2) and the fourth highly doped layer (6) are completely removed at the side walls of the trenches.

6. Method according to claim 4 or 5, characterized in that the material of the metal layer (1, 2) and also of the mask (8) is aluminium.


**Revendications**

1. Composant semi-conducteur de puissance comprenant au moins trois couches successives de conductibilité différente, dans lequel :

- les deux premières couches (3, 4) s'étendent jusqu'à une première surface du composant;

- la première couche (3) est fortement dopée;
- un premier plan de contact (1) et un second (2) divisés en sections sont prévus pour établir le contact avec la première couche (3) ou la seconde couche (4) et confèrent à la première surface du composant une structure en échelons; caractérisé en ce que:
- la première couche (3) a une épaisseur de 3-5 µm;
- la seconde couche (4) est faiblement dopée et a une épaisseur de 40 µm au maximum;
- les échelons ont une hauteur entre 10 µm et 20 µm et une largeur entre 20 µm et 300 µm, et
- le rapport entre la surface du premier plan de contact (1) et la surface du second plan de contact (2) se situe entre 1 et 4.

2. Composant semi-conducteur de puissance suivant la revendication 1, caractérisé en ce qu'une quatrième couche (6) ayant une conductibilité du type opposé à celui de la première couche (3) est prévue à la surface du second plan de contact (2).

3. Composant semi-conducteur de puissance suivant la revendication 1, caractérisé en ce que la première couche (3) a un dopage de $5 \cdot 10^{18}$ à $5 \cdot 10^{20}$ atomes par $cm^3$ et la seconde couche (4) a un dopage de $5 \cdot 10^{14}$ à $5 \cdot 10^{16}$ atomes par $cm^3$.

4. Procédé de fabrication d'un composant semi-conducteur suivant la revendication 1, suivant lequel procédé:
- on forme une première couche (3) fortement dopée par diffusion sur une seconde couche (4) de matière semi-conductrice faiblement dopée;
- on forme par-dessus, par voie photolithographique, un masque (8) d'une matière résistant à la morsure qui fixe sensiblement la structure en forme d'échelons de la surface;
- on forme ensuite des creux par morsure jusque dans la seconde couche faiblement dopée;
- on élimine le masque (8); caractérisé en ce que;
- on exécute la diffusion de la première couche fortement dopée (3) avec une profondeur de pénétration d'environ 3-5 µm et on restreint l'épaisseur de la seconde couche à un maximum de 40 µm;
- on utilise un masque (8) de façon que le rapport entre la surface d'un premier plan de contact (1) et la surface d'un second plan de contact (2) se situe entre 1 et 4;
- on execute la morsure des creux par décapage ionique réactif avec une profondeur de morsure de 10 µm à 20 µm et une distance entre creux de 20 µm à 300 µm;
- après élimination du masque (8), on forme par évaporation une couche métallique mince (1, 2) pour établir le contact sur toute la surface, et
- on réalise la morsure isotrope de la surface jusqu'à ce que la mince couche métallique (1, 2) soit éliminée complètement sur les parois latérales des creux.

5. Procédé de fabrication d'un composant semi-conducteur suivant la revendication 2, suivant lequel procédé :
- on forme une première couche (3) fortement dopée par diffusion sur une seconde couche (4) de matière semi-conductrice faiblement dopée;
- on forme par-dessus, par voie photolithographique, un masque (8) d'une matière résistant à la morsure qui fixe sensiblement la structure en forme d'échelons de la surface;
- on forme ensuite des creux par morsure jusque dans la seconde couche faiblement dopée;
- on élimine le masque (8); caractérisé en ce que:
- on exécute la diffusion de la première couche fortement dopée avec une profondeur de pénétration d'environ 3-5 µm et on restreint l'épaisseur de la seconde couche à un maximum de 40 µm;
- on utilise un masque (8) de façon que le rapport entre la surface d'un premier plan de contact (1) et la surface d'un second plan de contact (2) se situe entre 1 et 4;
- on exécute la morsure des creux par décapage ionique réactif avec une profondeur de morsure de 10 µm à 20 µm et une distance entre creux de 20 µm à 300 µm;
- avant la formation du masque (8) sur la première couche (3) fortement dopée, on applique une couche de dioxyde de silicium (7);
- après élimination du masque (8), on forme par diffusion la quatrième couche (6) fortement dopée à la surface du second plan de contact;
- après la diffusion de la quatrième couche fortement dopée, on élimine complètement la couche de dioxyde de silicium (7);
- on forme par évaporation une couche métallique mince (1, 2) pour établir le contact sur toute la surface;
- on réalise la morsure isotrope de la surface jusqu'à ce que la couche métallique (1, 2) et la quatrième couche (6) hautement dopée soient complètement éliminées sur les parois latérales des creux.

6. Procédé suivant la revendication 4 ou 5, caractérisé en ce que la matière de la couche métallique (1, 2) et du masque est l'aluminium.

Fig. 1

Fig. 2

Fig. 3